# EUROPEAN PATENT APPLICATION

(11) **EP 4 592 157 A1**
(43) Date of publication of application: **30.07.2025**
(21) Application number: 23871539.5
(22) Date of filing: 16.08.2023
(51) Int. Cl.: B61B 13/00

(54) **TRAVEL RAIL AND TRAVELING VEHICLE SYSTEM**

(30) Priority: 29.09.2022 JP 2022156040
(71) Applicant: Murata Machinery, Ltd., Kyoto-shi, Kyoto 601-8326 (JP)
(72) Inventor: TORAZAWA Masayoshi, Inuyama-shi, Aichi 484-8502 (JP)
(74) Representative: Stöckeler, Ferdinand
(86) International application number: PCT/JP2023/029606
(87) International publication number: WO 2024/070297

(57) **Abstract**

In the overhead vehicle system, the first rail and the second rail are disposed in a grid. The first rail (or second rail) is disposed such that a gap through which the connecting part below the traveling wheel is able to pass is formed between the rail and an intersection rail disposed at an intersection in the grid. The first rail (or the second rail) includes an auxiliary member configured to be removably attached to the attachment portion provided at the end in the longitudinal direction, the auxiliary member protruding from the rail upper surface of the rail and coming into contact with the auxiliary wheel.

## Description

### Technical Field

The present disclosure relates to a travel rail and a traveling vehicle system.

### Background Art

In traveling vehicle systems, a traveling vehicle is known in which a traveling part has a driving wheel and an auxiliary wheel. For example, as described in Patent Literature 1, a pair of auxiliary wheels of front and rear are provided with respect to the drive wheel. The positions of the drive and the auxiliary wheel are set such that the lower end of the drive wheel and the lower end of the auxiliary wheel do not pass over a gap between rails simultaneously. The rails constituting a track each have an end that is provided with an auxiliary track with which the auxiliary wheel is in contact, and a pair of the auxiliary wheels are disposed such that their lower ends are higher than the lower end of the drive wheel. The auxiliary track with which the auxiliary wheels are in contact is provided on an end of the track. The auxiliary wheels are placed on the auxiliary track (supported by the auxiliary track) only when the drive wheel passes over the gap, thereby making it possible to minimize wear caused by the auxiliary wheel and the auxiliary track being in contact with each other while preventing the drive wheel from falling into the gap. Consequently, vibration of the traveling vehicle is suppressed.

### Citation List

### Patent Literature

[Patent Literature 1] Japanese Patent No. 7040636

### Summary of Invention

### Technical Problem

In the conventional technology described above, an auxiliary track is formed on the track (travel rail). In other words, the auxiliary track is integrated with the travel rail.

It is required that the auxiliary track (auxiliary travel surface on which the auxiliary wheels are placed) protrudes from the travel surface of the travel rail by a specified height with the travel surface of the travel rail being formed flat. Such an integrated type of travel rail requires machining processing or the like of rail members, and thus, production costs tend to increase. In addition, in the case of changing a height or a position of the auxiliary track on a particular travel rail, the entire rail is required to be replaced.

The present disclosure describes a travel rail and a traveling vehicle system enabling cost reduction and facilitate adjustment of an auxiliary travel surface.

### Solution to Problem

An aspect of the present disclosure is travel rail on which a traveling vehicle travels, the traveling vehicle having a traveling wheel coming into contact with a rail upper surface and auxiliary wheels each located above the rail upper surface when the traveling wheel comes into contact with the rail upper surface, and which is disposed in a grid in a first direction and in a second direction orthogonal to the first direction, the travel rail being disposed such that a gap through which a connecting part provided below the traveling wheel is able to pass, is formed between the travel rail and an intersection rail disposed at an intersection in the grid, the travel rail including an auxiliary member configured to be removably attached to an attachment portion provided at an end of a longitudinal direction, the auxiliary member protruding from the rail upper surface and coming into contact with the auxiliary wheel.

According to this travel rail, when the traveling wheel passes over the gap formed between the travel rail and the intersection rail, the auxiliary wheels are supported on the auxiliary travel surface of the auxiliary member. The auxiliary member is removably attached to the attachment portion, and thus a rail body and the auxiliary member can be produced separately (by using different molds, or other method), and thus cost reduction is enabled. In addition, the auxiliary member being removably attached to the attachment portion facilitates adjustment of the position of the auxiliary travel surface and change of the height thereof by replacement.

The attachment portion may be a groove formed on the end in the longitudinal direction and extending in the longitudinal direction. This configuration facilitates the attachment of the auxiliary members. If the groove is longer than the auxiliary member, the auxiliary member can be moved along the groove, and the position of the auxiliary member, including the auxiliary travel surface, can be easily adjusted.

The auxiliary member may have a body, a holding section including a holding slope being in contact with the body from at least one side of the longitudinal direction, and a screw penetrating and clamping the body and the holding section together, and by tightening the screw in a state where the body, the holding section, and the screw are disposed in the groove, the body may be attached to the attachment portion. This configuration makes it possible to attach the body (auxiliary member) simply by tightening the screws. The auxiliary member can be removed simply by loosening the screw. It is easy to attach and detach the auxiliary member to and from the rail body. In addition, by replacing only the body constituting the auxiliary member, the length or height or the like of the auxiliary travel surface can be changed more easily and at lower cost.

The auxiliary travel surface of the auxiliary member coming into contact with the auxiliary wheel may be formed at a position shifted to one side or the other side of the centerline of the groove in a width direction orthogonal to the longitudinal direction and along the rail upper surface. This configuration is advantageous in the case in which a pair of the auxiliary wheels are provided and the traveling positions of the auxiliary wheels in the direction of an axle is shifted. In other words, by fitting a common body into the groove in an opposite direction, two types of auxiliary travel surfaces with different positions in the direction of the axle can be formed. Note that the traveling positions of the auxiliary wheels being shifted allows the auxiliary wheel to come into contact with the auxiliary travel surface only when the traveling wheel is off the travel surface. Therefore, when driving force is generated by the traveling wheels, the auxiliary wheel and the auxiliary travel surface do not allow the traveling wheel to move away from the travel surface.

As another aspect of the present disclosure, a traveling vehicle system may be provided including any of the above travel rail and the traveling vehicle configured to travel along the travel rail. According to this traveling vehicle system, the auxiliary wheels traveling on the auxiliary members can suppress the traveling wheels of the overhead traveling vehicle from falling into a gap when passing over the gap, thereby suppressing the vibration of the overhead traveling vehicle. At least any one of the height, the length, or the position of the auxiliary member for being in contact with the auxiliary wheel (for supporting the auxiliary wheel) can be easily changed.

As yet another aspect of the present disclosure, a traveling vehicle system may be provided including any of the above travel rail and the traveling vehicle configured to travel along the travel rail, in which the auxiliary wheels are disposed, in the width direction, at positions shifted to one side and the other side of the centerline of the groove. According to this traveling vehicle system, the traveling vehicle is provided with a pair of the auxiliary wheels, and the traveling positions in the direction of the axles of the auxiliary wheels are shifted. On the travel rail, two types of auxiliary travel surfaces are formed in different positions in the direction of the axle, so that one of the pair of auxiliary wheels is supported by these auxiliary travel surfaces. Note that the traveling positions of the auxiliary wheels being shifted allows the auxiliary wheel to come into contact with the auxiliary travel surface only when the traveling wheel is off the travel surface. Therefore, when the driving force is generated by the traveling wheel, the auxiliary wheels and the auxiliary travel surfaces reliably prevent the traveling wheel from separating from the travel surface.

### Advantageous Effects of Invention

According to the present disclosure, cost reduction is possible, and it is also easy to adjust the height or the position or the like of the auxiliary travel surface.

### Brief Description of Drawings

[FIG. 1] FIG. 1 is a perspective diagram illustrating an example of a traveling vehicle system according to an embodiment.
[FIG. 2] FIG. 2 is an exploded perspective view illustrating four rail units constituting a rail assembly in FIG. 1 and a connecting members configured to link those rail units together.
[FIG. 3] FIG. 3 is a side view of an overhead traveling vehicle in FIG. 1.
[FIG. 4] FIG. 4 is a perspective view illustrating the overhead traveling vehicle in FIG. 1.
[FIG. 5] FIG. 5 is a perspective view illustrating only a rail portion of a rail assembly.
[FIG. 6] FIG. 6 is a sectional view illustrating a connecting part between a plurality of rail units.
[FIG. 7] FIG. 7 is a perspective view illustrating an example of a travel rail according to the embodiment.
[FIG. 8] FIG. 8(a) is a side view illustrating a state of a traveling wheel traveling in front of a gap between the rails, and FIG. 8(b) is a plan view of FIG. 8(a).
[FIG. 9] FIG. 9(a) is a side view illustrating a state of the traveling wheel attempting to cross the gap between the rails, and FIG. 9(b) is a side view of a state illustrating the traveling wheel having finished crossing the gap.
[FIG. 10] FIG. 10 is an exploded perspective view illustrating auxiliary members to be attached to the rail.
[FIG. 11] FIG. 11(a) is a side view of the auxiliary members in FIG. 10 before assembly, and FIG. 11(b) is a side view of the auxiliary member after assembly (when fixed).
[FIG. 12] FIG. 12 is a cross-sectional view along XII-XII line in FIG. 11(b).

### Description of Embodiments

The following describes the embodiments of the present disclosure with reference to the drawings. In the description of the drawings, identical elements are marked with the same symbol and redundant explanations are omitted. In the drawings, for convenience of explanation, each configuration according to the embodiment is represented at a different scale as appropriate. In some drawings, the XYZ Cartesian coordinate system is also shown. In the following description, this coordinate system will be referred to for ease of explanation. Hereafter, one direction along a horizontal plane is an X direction (first direction), a direction orthogonal to the X direction and along the horizontal plane is a Y direction (second direction), and a vertical direction is a Z direction.

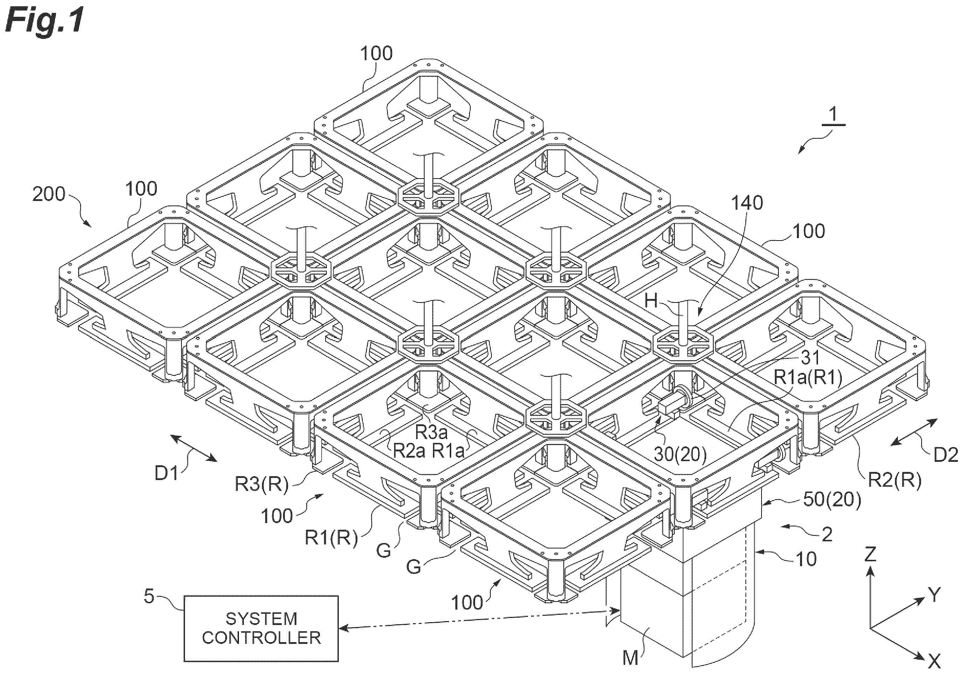

As illustrated in FIG. 1, the overhead vehicle system (traveling vehicle system) 1 according to the embodiment is a grid system (transport system or tracked cart system) for transporting an article M by means of an overhead traveling vehicle 2 in a clean room of a semiconductor manufacturing plant, for example. The overhead vehicle system 1, for example, has a plurality of the overhead traveling vehicles 2 (hereinafter collectively referred to as "traveling vehicles 2"), a system controller 5 configured to control the traveling vehicles 2, and a track R on which a plurality of the traveling vehicles 2 travel. The traveling vehicles 2 move along the track R of the overhead vehicle system 1. The traveling vehicles 2 run along the track R and transport the article M, such as a FOUP (Front Opening Unified Pod) configured to house semiconductor wafers, a reticle Pod configured to house reticles, or the like. The traveling vehicles 2 each may be referred to as a cart, a transport vehicle, a transport cart, a traveling cart, or the like. The traveling vehicles 2 enable high-density transportation of the articles M and increase the transport efficiency of the articles M. The overhead vehicle system 1 may also include only one traveling vehicle 2.

The track R is provided on or near the ceiling of a clean room or other building. The track R is provided adjacent to, for example, processing equipment, a stocker (automatic warehouse), or the like. The processing equipment includes, for example, exposure equipment, coater developers, deposition equipment, etching equipment, or the like, the processing equipment applying various types of processing to the semiconductor wafers in the articles M transported by the traveling vehicles 2. The stocker stores the articles M to be transported by the traveling vehicle 2.

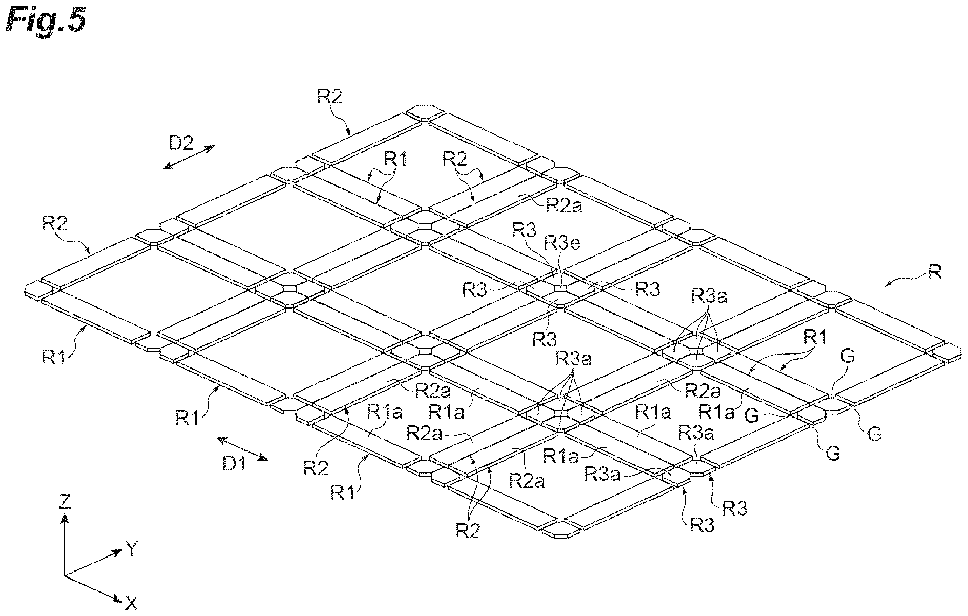

The tracks R are arranged in a grid in plan view (see also FIG. 5). The track R extends along the horizontal direction. In the present embodiment, the track R is constructed by a plurality of rail units 100 each including a first rail R1, a second rail R2, and an intersection rail R3, the rail units 100 being provided side by side in the X direction and in the Y direction. The overhead vehicle system 1 includes the rail units 100 provided side by side in the X direction and in the Y direction, and a plurality of connecting members 140 each configured to connect the rail units 100 to each other. The rail units 100 and the connecting members 140 form a rail assembly 200. The rail assembly 200 is hung from an unillustrated ceiling or the like by a plurality of hanging members H at a portion where the rail units 100 are connected to each other by the connecting members 140.

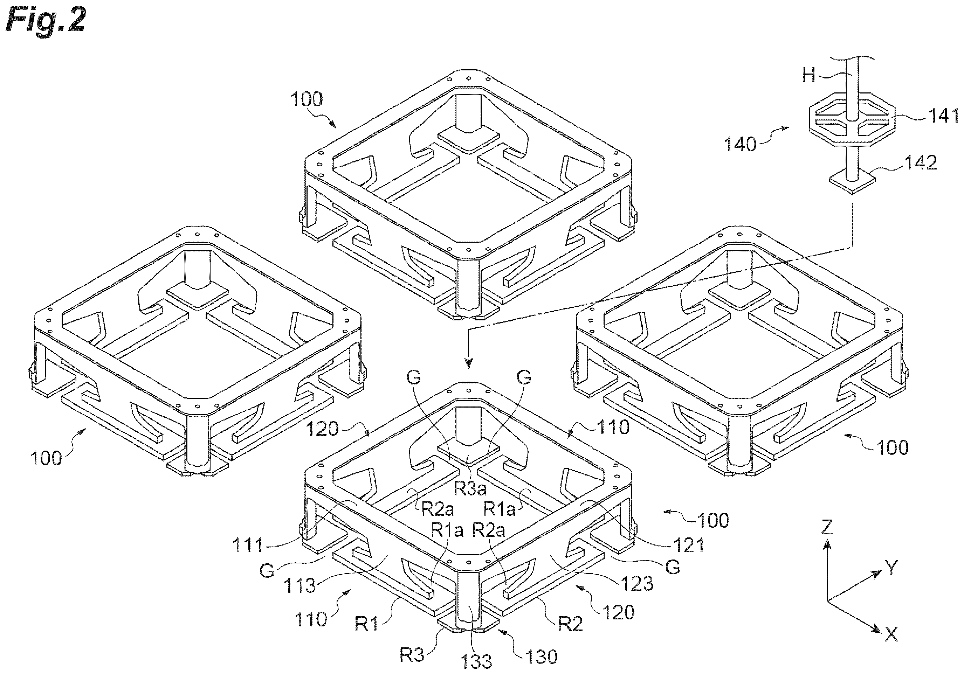

FIG. 2 is an exploded perspective view of the four rail units 100 constituting the rail assembly 200 in FIG. 1 and the connecting member 140 configured to connect those rail units 100. Each of the rail units 100 is a member of a rectangular shape (frame shape) and has the same configuration. Each rail unit 100 includes two first rail members 110 disposed along the X direction, two second rail members 120 disposed along the Y direction, and four intersection rail members 130 disposed such that gaps are formed on extensions of the first rail member 110 and the second rail member 120 (i.e., at the intersection of the grid). When the rail unit 100 is viewed in plan view, the two parallel first rail members 110 and the two parallel second rail members 120 are disposed in a square shape, and the four intersection rail members 130 are disposed at the apexes of the square.

Each rail unit 100 is made of metal, for example, and is a unit in which the first rail member 110, the second rail member 120, and the intersection rail member 130 are integrated after each thereof is molded. Each of the first rail members 110 includes a first beam portion 111 disposed at an upper end position of the rail unit 100 and extending in the X direction, a first rail (travel rail) R1 disposed at a lower end position of the rail unit 100 and extending in the X direction, and a first support wall 113 disposed between the first beam portion 111 and the first rail R1, and joined to the first beam portion 111 and the first rail R1. Each of the second rail members 120 includes a second beam portion 121 disposed at the upper end position of the rail unit 100 and extending in the Y direction, a second rail (travel rail) R2 disposed at the lower end position of the rail unit 100 and extending in the Y direction, and a second support wall 123 disposed between the second beam portion 121 and the second rail R2 and joined to the second beam portion 121 and the second rail R2. A plurality of the first beam portions 111 and a plurality of the second beam portions 121 form a grid structure, the structure extending along an XY plane at the upper end position of the rail assembly 200. The first support wall 113 extends along the XZ plane. The second support wall 123 extends along the YZ plane.

The intersection rail member 130 includes an intersection support column 133 extending along the Z direction (vertical direction) at the position where the first beam portion 111 and the second beam portion 121 are joined at right angles, and an intersection rail R3 at a lower end of the intersection support column 133.

As illustrated in FIG. 1 and FIG. 5, a plurality of the first rails R1 each extend along the X direction. A plurality of the second rails R2 each extend along the Y direction. The track R is formed in a grid in plan view by the first rails R1 and the second rails R2. The track R is formed in a plurality of squares by the first rails R1 and the second rails R2. The intersection rail R3 is disposed at a portion corresponding to the intersection between the first rail R1 and the second rail R2. The intersection rail R3 is adjacent to the first rail R1 at an interval each other in an X direction. The intersection rail R3 is adjacent to the second rail R2 at an interval each other in the Y direction. The intersection rail R3 is used in every case when the traveling vehicle 2 travels along the first rail R1, when the traveling vehicle 2 travels along the second rail R2, or when the traveling vehicle 2 travels from the first rail R1 to the second rail R2 or from the second rail R2 to the first rail R1.

Each rail unit 100 forms a track R of a square shape (or a rectangular shape) corresponding to a single square in its interior thereof. When the rail units 100 are aligned in the X direction and the Y direction, the first rails R1 extend in a series in the X direction and the second rails R2 extend in a series in the Y direction. The two intersection rails R3 are disposed at intervals between one first rail R1 and another first rail R1 on the X direction line. On the Y direction line, the two intersection rails R3 are disposed at intervals between the one second rail R2 and another second rail R2. The track R is described in another viewpoint. When focusing on the four squares made of two squares aligned in the X direction and two squares aligned in the Y direction, the four intersection rails R3 adjacent to each other in the X direction and the Y direction are disposed at intervals (with respect to the first rail R1) between the two first rails R1 adjacent to each other in the Y direction and another two first rails R1 adjacent to each other in the Y direction. The same four intersection rails R3 as above are disposed at intervals (with respect to the second rail R2) between the two second rails R2 adjust each other in the X direction and another two second rails R2 adjacent to each other in the X direction.

In a rail assembly 200, the first rails R1, the second rails R2, and the intersection rails R3 are disposed at intervals from each other, and thereby a track R is constructed. A gap G corresponding to the above interval is formed between each first rail R1 and the corresponding intersection rail R3. A gap G corresponding to the above interval is formed between each second rail R2 and the corresponding intersection rail R3. The gap G in the track R has a constant size. Each of the first rails R1 includes a first travel surface R1a of being flat and horizontal on its upper surface, and the traveling wheel 31 of the traveling vehicle 2 travels on the first travel surface R1a in the X direction (first traveling direction D1). Each of the second rails R2 includes a second travel surface R2a of being flat and horizontal on its upper surface, and the traveling wheel 31 of the traveling vehicle 2 travels on the second travel surface R2a in the Y direction (second traveling direction D2). The intersection rail R3 includes an intersection travel surface R3a of being flat and horizontal on its upper surface. The heights of the first travel surface R1a, the second travel surface R2a, and the intersection travel surface R3a are equal throughout the entire track R. The first travel surface R1a, the second travel surface R2a, and the intersection travel surface R3a are disposed on the same or substantially the same horizontal plane.

For example, there is no gap having a size of the gap G formed between the four intersection rails R3 described above. When the traveling vehicle 2 passes in a straight line through the rail units 100, the traveling wheel 31 of the traveling vehicle 2 travels on the intersection travel surface R3a. During the traveling, the traveling wheel 31 passes over any two of the four intersection rails R3 described above. Alternatively, when the traveling vehicle 2 changes the traveling direction between the rail units 100 (changes the traveling direction by 90 degrees, i.e., turns), the traveling wheel 31 of the traveling vehicle 2 passes over the intersection travel surface R3a (while changing the direction).

As described above, in the rail assembly 200, the first rail member 110, the second rail member 120, and the intersection rail member 130 constitute the track R in a grid. The layout of the track R configured in a grid in the overhead vehicle system 1 may be adjusted or modified as appropriate by providing the rail units 100 in any desired arrangement (including adding or deleting of the rail unit 100).

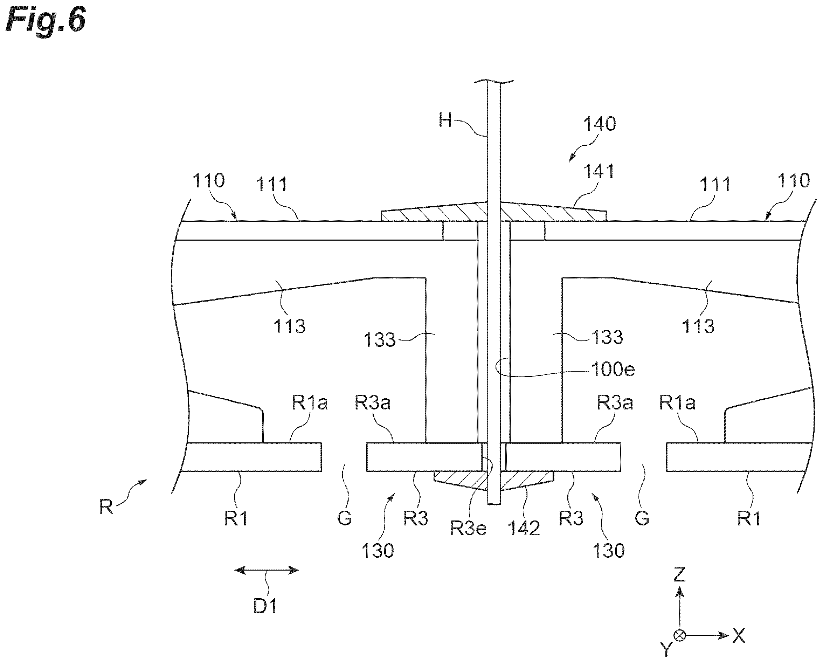

Referring to FIGs. 2 and 6, the connection structure of the rail unit 100 with the connecting member 140 is described. As illustrated in FIGs. 2 and 6, each of the connecting members 140 includes an upper connecting member 141 and a lower connecting member 142. The upper surface of any one of the four corners of the plurality of (typically four) rail units 100 is attached to an upper connecting member 141 of a plate shape or a frame shape extending horizontally. The upper connecting member 141 is in contact with near the intersection of the first beam portion 111 and the second beam portion 121 in each of the rail units 100. The lower connecting member 142 of a plate shape or a frame shape extending horizontally supports the lower surface of any one of the four corners of the plurality of (typically four) rail units 100. The lower connecting member 142 is in contact with the intersection rail R3 in each of the rail units 100.

A hanging member H of a bar shape extending in the vertical direction penetrates through the upper connecting member 141 and the lower connecting member 142. The upper connecting member 141 and/or the lower connecting member 142 are fixed to the rail unit 100 by an unillustrated fastening member or the like, and thereby the rail units 100 are connected to each other. Note that a space 100e extending in the Z direction is formed between the rail units 100, and a space R3e extending in the Z direction is formed between the four intersection rails R3 adjacent to each other in the X and Y directions (center portion in plan view). The hanging member H is inserted into the space 100e and the space R3e, and the upper connecting member 141 and/or the lower connecting member 142 are fixed to the hanging member H.

The overhead vehicle system 1 includes a communication system (not illustrated). The communication system is used for communication between the traveling vehicle 2 and the system controller 5. The traveling vehicle 2 and the system controller 5 are each communicatively connected via a communication system.

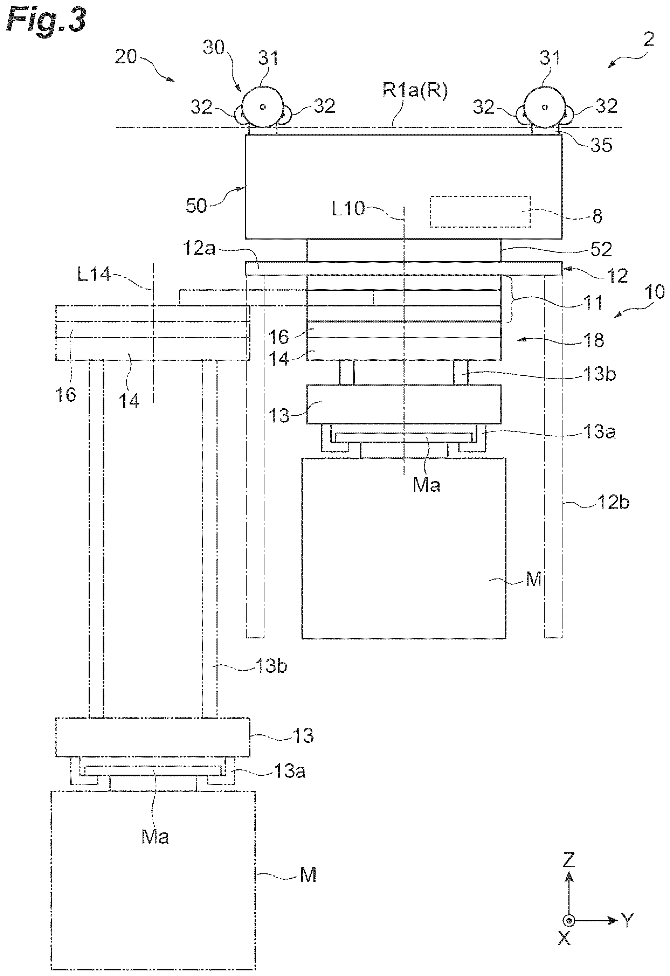

The configuration of the traveling vehicle 2 is then described with reference to FIGs. 1, 3 and 4. As illustrated in FIGs. 1 and 3, the traveling vehicle 2 is provided to be able to travel along the track R. The traveling vehicle 2 has a traveling cart 20 configured to travel on the track R and a body 10 configured to be attached to a bottom part of the traveling cart 20 and can swivel with respect to the traveling cart 20. The traveling cart 20 includes a cart unit 50 of a rectangular shape, for example, disposed below the track R, traveling parts 30 provided at the four corner positions of the cart unit 50 in plan view and protruding upward from the cart unit 50, and four wheel swivel mechanisms 40 configured to swivel the four traveling wheels 31 in the traveling parts 30, respectively, with respect to the cart unit 50. Inside the cart unit 50, a cart controller (control section) 8 is provided.

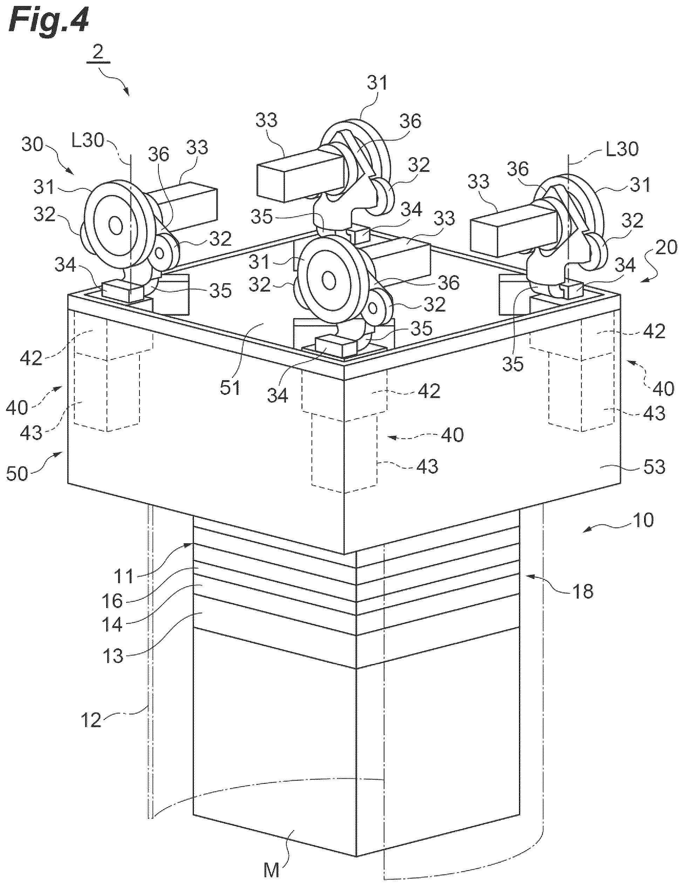

The body 10 is disposed below the track R. As illustrated in FIGs. 3 and 4, the body 10 has a body frame 12 formed in a cylindrical shape, for example. The body frame 12 includes a top panel part 12a of a disc shape and a cylindrical frame 12b hanging from a periphery of the top panel part 12a, and has an open lower surface. The body 10 is formed to have dimensions fitting into one square in the track R (see FIG. 1)
in plan view. The traveling vehicle 2 can pass another traveling vehicle 2 traveling on the adjacent first rail R1 or the adjacent second rail R2. The body 10 includes a transfer device 18 disposed inside the body frame 12. The transfer device 18 has a rectangular shape in plan view, for example. The cylindrical frame 12b is open in part of a circumferential direction. An area in which an open portion (cutout) is formed is large enough to allow the transfer device 18 to pass through. The transfer device 18, when moving horizontally, passes through the open portion of the cylindrical frame 12b.

The body 10 is attached to the bottom part of the cart unit 50 and can swivel around a rotation axis L10 in the Z direction with respect to the cart unit 50. The traveling wheels 31 at the four corner positions of the cart unit 50 are on the track R (on the first travel surface R1a, the second travel surface R2a, or the intersection travel surface R3a). The cart unit 50 is hung from the track R via the four traveling wheels 31 and the four wheel swivel mechanisms 40. The four traveling wheels 31 allow the cart unit 50 and the body 10 to be hung stably and the body 10 to travel stably. In other words, the traveling vehicle 2 is hung and supported by the traveling wheels 31 traveling along the track R and moves below the track R.

The transfer device 18 moves horizontally with respect to the body 10 and transfers the articles M to and from a load port (placing platform). The transfer device 18 is provided below the top panel part 12a of the body frame 12. The body 10 including the transfer device 18 is rotatable around the rotation axis L10 by a rotation drive section such as an unillustrated electric motor provided in the top panel part 12a. The transfer device 18 has an article holding section 13 configured to hold an article M on an underside of the track R, a lifting drive section 14 configured to raise and lower the article holding section 13 in the vertical direction, and a slide mechanism 11 configured to slide the lifting drive section 14 in the horizontal direction. The slide mechanism 11 is held on the lower surface of the top panel part 12a. Between the slide mechanism 11 and the lifting drive section 14, a rotation drive section 16 configured to rotationally drive the lifting drive section 14 with respect to the slide mechanism 11 around the rotation axis L14. The rotation drive section 16 is provided below the slide mechanism 11, and the lifting drive section 14 is provided below the rotation drive section 16. The article holding section 13 is provided below the lifting drive section 14 via a plurality of the hanging members 13b. The load port is a transfer destination or a transfer origin of the traveling vehicle 2 and a point at which the articles M are transferred to or from the traveling vehicle 2.

The article holding section 13 grips a flange part Ma of the article M, thereby hanging and holding the article M. The article holding section 13 is, for example, a chuck having a claw part 13a configured to be movable in the horizontal direction. The article holding section 13 advances the claw part 13a below the flange part Ma of the article M to raise the article holding section 13, thereby holding the article M. The article holding section 13 is connected to the hanging member 13b, such as a wire or belt.

The lifting drive section 14 is, for example, a hoist, the hoist lowering the article holding section 13 by unrolling the hanging member 13b and raising the article holding section 13 by reeling in the hanging member 13b. The lifting drive section 14 is controlled by the cart controller 8 to lower or raise the article holding section 13 at a predetermined speed. In addition, the lifting drive section 14 is controlled by the cart controller 8 to hold the article holding section 13 at a target height.

The slide mechanism 11 has a plurality of movable plates disposed on top of each other in the Z direction, for example. By causing the body 10 to swivel, the slide mechanism 11 moves the rotation drive section 16, the lifting drive section 14, and the article holding section 13 attached to the lowest movable plate in any desired direction in the horizontal plane. The swivel angle of the body 10 with respect to the cart unit 50 determines the direction of movement of the movable plate in the slide mechanism 11. In the body 10, the orientation of the transfer device 18 and the body frame 12 is set such that the direction of movement of the movable plate and the position of the open portion of the cylindrical frame 12b coincide.

The rotation drive section 16 includes, for example, an electric motor or the like and rotates the lifting drive section 14 (and the article holding section 13) within a predetermined angular range around the rotation axis L14 extending in the vertical direction. The angle that is rotatable by the rotation drive section 16 is any desired angle smaller than or equal to 180 degrees, for example, but the upper limit is not limited to 180 degrees. The rotation drive section 16 allows the article holding section 13 (or the article M held by the article holding section 13) held out sideways to be oriented in any desired direction. The slide mechanism 11 and the rotation drive section 16 are controlled by the cart controller 8. Note that even when the movable plate of the slide mechanism 11 has not moved and is stowed (in a state indicated by the solid line in FIG. 3), the lifting drive section 14 can be rotated by the rotation drive section 16. In that case, for example, the rotation axis L14 of the lifting drive section 14 coincides with the rotation axis L10 of the body 10.

The cart unit 50 has a support member 52 of a cylindrical shape (cylindrical member) at the lower end. The top panel part 12a of the body frame 12 is attached in a rotatable manner to the lower surface side of the support member 52. For example, an unillustrated rotation drive section, such as an electric motor, is provided in the top panel part 12a. The driving force of the rotation drive section is transmitted to the support member 52, and thereby the body frame 12 rotates around the rotation axis L10 extending in the vertical direction with respective to the cart unit 50. The angle at which the body frame 12 is rotatable is any desired angle between 360 degrees and 540 degrees, for example, but the upper limit is not limited to 540 degrees and the lower limit is not limited to 360 degrees. The slide mechanism 11 is attached to the lower surface side of the top panel part 12a, and the top panel part 12a supports the slide mechanism 11. The body frame 12 and the transfer device 18 are integrated, and the body frame 12 and the transfer device 18 rotate together. The traveling vehicle 2 can receive and deliver the article M to the load port by using the transfer device 18.

Note that an unillustrated cover may be attached to an outer surface side of the cylindrical frame 12b. In that case, the cover encloses the transfer device 18 and the article M held in the transfer device 18. The cover has a cylindrical shape with its lower end open and has a cutout shape where the movable plate of the slide mechanism 11 protrudes therefrom (the open portion described above).

The traveling part 30 has four traveling wheels 31. Each of the traveling wheels 31 is provided with two auxiliary wheels 32. As illustrated in FIG. 4, the traveling wheels 31 are provided at the four corner positions of the cart unit 50 to protrude upward from the upper surface cover 51. Each of the traveling wheels 31 is rotatable around the horizontal or nearly horizontal axle along the XY plane. On a rotation shaft of each of the traveling wheels 31, a traveling drive motor 33 is provided. Each of the traveling wheels 31 is rotationally driven by the driving force of the traveling drive motor 33. The traveling drive motor 33, for example, is configured to be switchable between forward rotation and reverse rotation. Each of the traveling wheels 31 rolls on the track R. Each of the traveling wheels 31 rolls on the travel surfaces R1a, R2a, and R3a of the first rail R1, second rail R2, and intersection rail R3 to drive the traveling vehicle 2. It is not limited to that all of the four traveling wheels 31 are rotationally driven by the driving force of the traveling drive motor 33, but there may be a configuration in which some of the four traveling wheels 31 are rotationally driven.

The four wheel swivel mechanisms 40 are fixed to an unillustrated frame inside the cart unit 50, and a base part 34 is connected to each of the wheel swivel mechanisms 40 via a swivel shaft of the wheel swivel mechanism 40. On the base part 34, the traveling wheel 31, the two auxiliary wheels 32, and the one traveling drive motor 33 are attached via a connecting part 35 and a support member 36. For example, an upper surface cover 51 of a square shape is provided on the upper surface of a housing 53, and the base parts 34 are disposed in cutouts formed in the four corners of the upper surface cover 51. The connecting part 35, the traveling wheels 31, the auxiliary wheels 32, and the traveling drive motor 33 are disposed above the upper surface cover 51.

As illustrated in FIGs. 3 and 4, the connecting part 35 connects the cart unit 50 (in detail, the wheel swivel mechanism 40 fixed in the cart unit 50) to the traveling wheels 31. With this connection structure, the cart unit 50 and the body 10 are disposed below the track R and in a state of being hung from the traveling part 30. The connecting part 35 is formed to be thick enough to pass through the gaps G between the first rail R1 and the intersection rail R3, and between the second rail R2 and the intersection rail R3. The support member 36 is provided in the top part of the connecting part 35 and supports in a rotatable manner the rotation shaft of the traveling wheel 31 and a rotation shaft of the auxiliary wheel 32. The support member 36 holds a relative position of the traveling wheel 31 and the auxiliary wheel 32.

As illustrated in FIG. 4, the traveling wheels 31 are provided in a swivelable manner around a swivel axis L30 extending in the vertical direction. The four swivel axes L30 are disposed at the apexes of a square in plan view, and the rotation axis L10 is placed at the center of the swivel axes L30. In other words, the four swivel axes L30 are disposed on four times symmetrical positions with respect to the rotation axis L10 of the body 10. In plan view, the position of the traveling wheel 31 is different (displaced) from the position of the swivel axis L30. The traveling wheel 31 can swivel by the wheel swivel mechanism 40, and thus can change the traveling direction of the traveling vehicle 2.

The auxiliary wheels 32 are disposed one each in front of and behind the traveling wheel 31 in the traveling direction. Each of the auxiliary wheels 32 is rotatable around the axis of a horizontal or nearly horizontal axle along the XY plane. The lower end of the auxiliary wheel 32 is set higher than the lower end of the traveling wheel 31, for example. Therefore, when the traveling wheels 31 are traveling on the travel surfaces R1a, R2a, and R3a, the auxiliary wheels 32 do not contact the travel surfaces R1a, R2a, and R3a. In addition, when the traveling wheels 31 pass through the gaps G between the first rail R1 and the intersection rail R3, and between the second rail R2 and the intersection rail R3, the auxiliary wheels 32 contact the auxiliary members provided on the first rail R1 and the second rail R2 (see below for details) to prevent the traveling wheels 31 from falling. It is not limited to that the two auxiliary wheels 32 are provided on one traveling wheel 31, but one auxiliary wheel 32 may be provided on one traveling wheel 31, for example.

The four wheel swivel mechanisms 40 are disposed, for example, at the four corner positions in the housing 53 of the cart unit 50. Each of the wheel swivel mechanism 40 has a steering motor 43, and a drive force transmission section 42 provided between the steering motor 43 and the traveling wheel 31. The drive force transmission section 42 is fixed to an unillustrated frame inside the cart unit 50. The drive force transmission section 42 is connected to the base part 34 via the swivel shaft. Each of the wheel swivel mechanisms 40 swivels the base part 34, the connecting part 35, the support member 36, the traveling wheel 31, the auxiliary wheel 32, and the traveling drive motor 33 in unison around the swivel axis L30. In a state where the traveling vehicle 2 is positioned in the center of each rail unit 100, each of the traveling wheels 31 is swiveled 90 degrees around the corresponding swivel axis L30. Consequently, the traveling wheels 31 swivel on the intersection rail R3. Consequently, the traveling vehicle 2 can turn. To turn is to switch from a first state in which the traveling vehicle 2 travels in the first travel direction D1 to a second state in which the traveling vehicle 2 travels in the second travel direction D2, or from the second state in which the traveling vehicle 2 travels in the second travel direction D2 to the first state in which the traveling vehicle 2 travels in the first travel direction D1. A turn of the traveling vehicle 2 is performed, for example, when the traveling vehicle 2 is at a standstill. The turn of the traveling vehicle 2 may be performed with the traveling vehicle 2 stopped but the articles M moving (for example, swiveling). The drive of the wheel swivel mechanism 40 is controlled by the cart controller 8.

As described above, the gap G is formed in the track R. When the traveling vehicle 2 travels on the first rail R1 and crosses the second rail R2, or when the traveling vehicle 2 travels on the second rail R2 and crosses the first rail R1, a part of the traveling vehicle 2 (in detail, for example, the connecting part 35) passes through the gap G.

Note that between the traveling wheel 31 and the wheel swivel mechanism 40 (for example, near the connecting part 35), the guide roller being in contact with a side of the intersection rail R3 may be provided. The guide roller prevents misalignment of the traveling cart 20 (traveling vehicle 2) with respect to the track R.

The traveling vehicle 2 includes an unillustrated position detection section configured to detect position information. The position detection section detects the current position of the traveling vehicle 2 by, for example, detecting position markers on the track R indicating position information. The position detection section detects position markers in a non-contact manner.

The cart controller 8 controls the traveling vehicle 2 in an overall manner. The cart controller 8 is a computer including a CPU (Central Processing Unit), ROM (Read Only Memory) and RAM (Random Access Memory), and the like. The cart controller 8 can be configured as software, for example, with which a computer program stored in ROM is loaded onto RAM and executed by the CPU. The cart controller 8 may be configured as hardware using an electronic circuit or the like. The cart controller 8 may include only a single device or include a plurality of devices. If the system includes a plurality of devices, connecting those devices via a communication network, such as the Internet or an intranet logically constructs a single cart controller 8. The cart controller 8 is installed in the cart unit 50, for example.

The cart controller 8 controls the traveling of the traveling vehicle 2 based on transport instructions. The cart controller 8 controls the traveling of the traveling vehicle 2 by controlling the traveling drive motor 33 and the steering motor 43, and the like. The cart controller 8 controls, for example, travel speed, operations related to stopping, and operations related to direction changes. The cart controller 8 controls the transfer operation of the traveling vehicle 2 based on the transfer instructions. The cart controller 8 controls the swiveling (rotation) of the body 10 (the body frame 12 and the transfer device 18), and thereby controls the transfer direction of the transfer device 18. The cart controller 8 controls the transfer operation of the traveling vehicle 2 by controlling the transfer device 18 and the like. The cart controller 8 controls the operation of gripping the article M to be disposed at a specified load port, and the operation of unloading the held article M down to a specified load port.

The system controller 5 is a computer including a CPU, ROM and RAM, and the like. The system controller 5 can be configured as software, for example, with which a computer program stored in ROM is loaded onto RAM and executed by the CPU. The system controller 5 may be configured as hardware using an electronic circuit or the like. The system controller 5 may include only a single device or include a plurality of devices. If the system controller 5 includes a plurality of devices, connecting those devices via a communication network, such as the Internet or an intranet logically constructs a single system controller 5. At least some of various controls of the system controller 5 may be performed by the cart controller 8.

The system controller 5 selects any of the traveling vehicles 2 configured to be able to transport the articles M and assigns the transport instructions to the selected traveling vehicle 2. The transport instructions include a travel instruction causing the traveling vehicle 2 to travel to the load port, and an instruction to grab the articles M disposed at the load port or an instruction to unload the articles M being held to the load port.

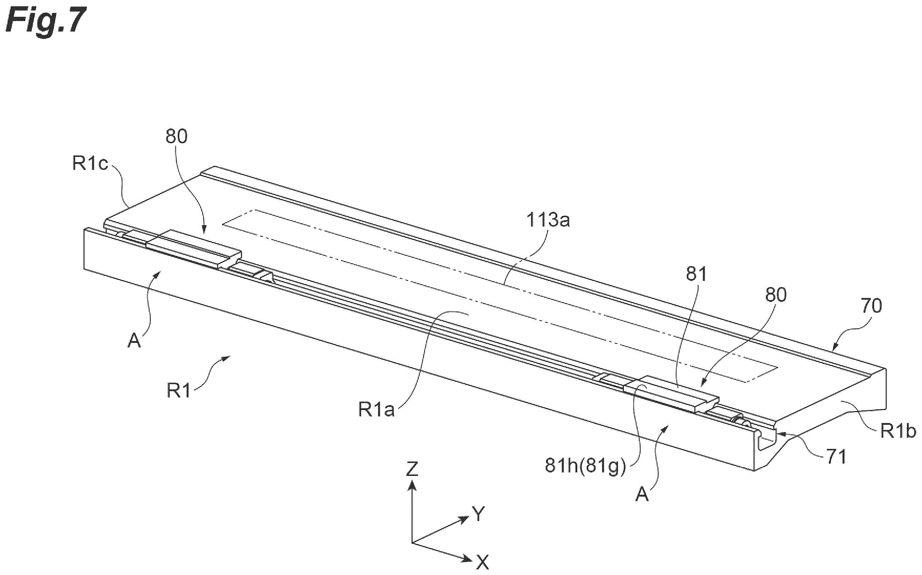

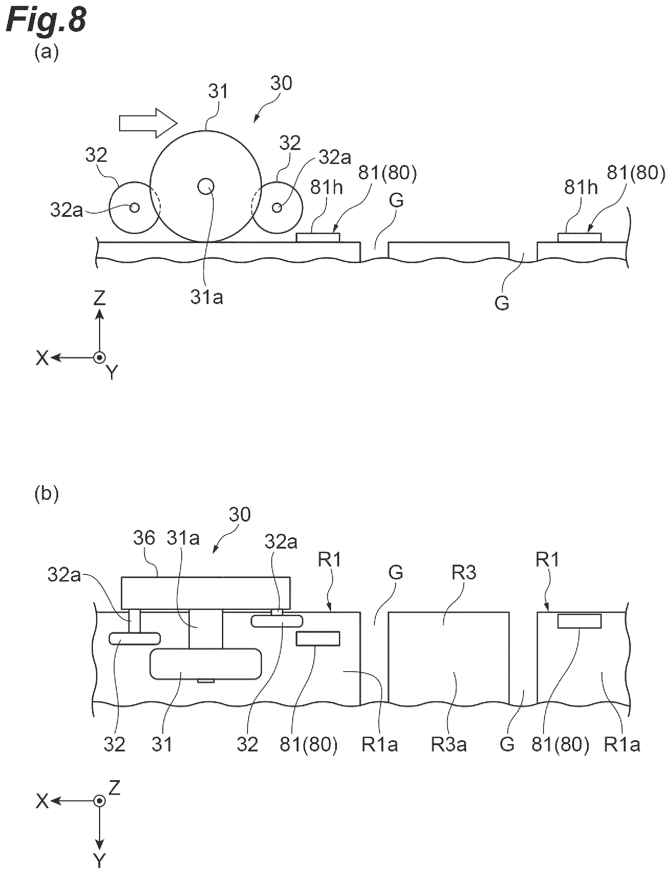

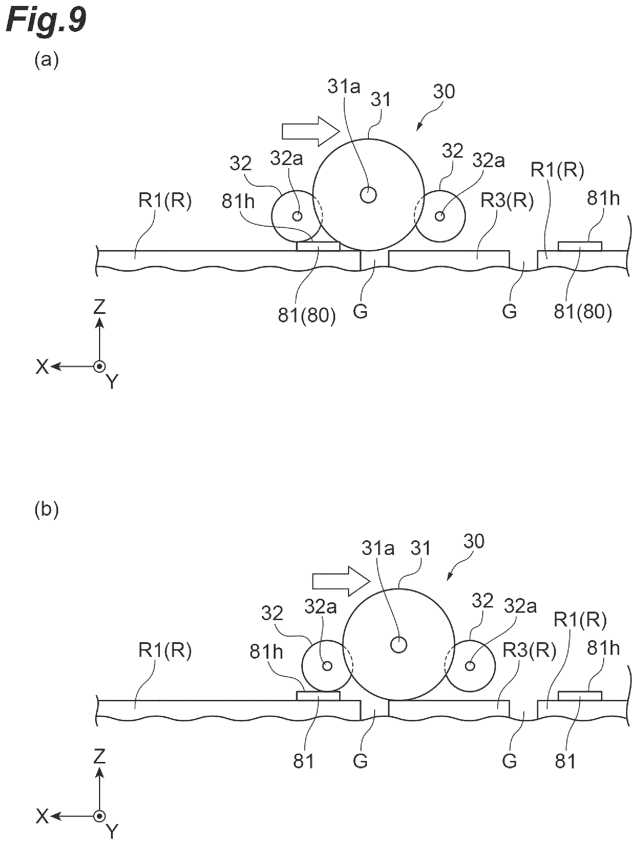

The detailed configuration of the first rail R1, which is the travel rail of the present embodiment, is then described with reference to FIGs. 7 through 12. FIG. 7 is a perspective view illustrating the first rail R1. FIG. 8(a) is a side view illustrating a state of the traveling wheel 31 traveling in front of the gap G between the rails, and FIG. 8(b) is a plan view of FIG. 8(a). FIG. 9(a) is a side view illustrating a state of the traveling wheel 31 attempting to cross the gap G between the rails, and FIG. 9(b) is a side view of a state illustrating the traveling wheel 31 having finished crossing the gap G. As illustrated in FIG. 7, the first rail R1 is disposed such that its longitudinal direction is along the X direction. The short side direction, or a width direction, of the first rail R1 is along the Y direction. The configuration of the second rail R2 is similar to that of the first rail R1. In the following description, only the configuration of the first rail R1 is explained, and the configuration of the second rail R2 is omitted.

The first rail R1 includes the first travel surface R1a. The first rail R1 is made of metal, for example. To the first rail R1, an auxiliary member 80 is attached to form an auxiliary travel surface 81h configured to support the auxiliary wheels 32. One first rail R1 has two auxiliary members 80 attached thereto. The auxiliary members 80 are removably attached to attachment portion A, A disposed at both ends of the rail body 70 in the longitudinal direction. Each of the auxiliary members 80 is a separate body from the rail body 70. In the present embodiment, the attachment portions A, A correspond to, for example, a single groove 71 extending straight in the longitudinal direction of the rail body 70. The groove 71, for example, penetrates through the rail body 70 in the X direction. Both ends of the groove 71 in the longitudinal direction (extending direction) are a pair of the attachment portions A, A. Thus, the first rail R1 includes the rail body 70 including the first travel surface R1a on which the traveling wheels 31 travels, and the auxiliary members 80 forming the auxiliary travel surfaces 81h higher than the first travel surface R1a. The first travel surface R1a is formed in the width direction of the first rail R1 between a joining area 113a where the lower end of the first support wall 113 is joined, and one end of the rail body 70 in the width direction where the groove 71 is provided. The auxiliary member 80 protrudes from the first travel surface R1a. Although not illustrated, the second rail R2 also includes the rail body 70 including the second travel surface R2a on which the traveling wheels 31 travels, and the auxiliary members 80 forming the auxiliary travel surfaces 81h higher than the second travel surface R2a. The auxiliary members 80 used in the track R, for example, are all identical parts and are common.

The auxiliary members 80 have bodies 81 each having an auxiliary travel surface 81h formed on the upper surface thereof. One body 81 is installed, for example, inside the one end face R1b of the first rail R1, that is, at a position a predetermined distance away from the one end face R1b. The other body 81 is also installed, for example, inside the other end face R1c of the first rail R1, that is, at a position a predetermined distance away from the other end face R1c. None of the auxiliary members 80 protrude from the one end face R1b and the other end face R1c and are within the rail body 70 in the X direction.

As illustrated in FIG. 8(a), the lower ends of the pair of auxiliary wheels 32 are positioned higher than the lower end of the traveling wheels 31. When the traveling wheels 31 travel on the first travel surface R1a, the pair of auxiliary wheels 32 are positioned away from the first travel surface R1a and a gap is formed between each of the auxiliary wheel 32 and the first travel surface R1a. That is, when the traveling wheel 31 is in contact with the first travel surface R1a (rail upper surface), the auxiliary wheels 32 are positioned above the first travel surface R1a. The diameters of the pair of auxiliary wheels 32 are approximately equal to each other. The diameter of each of the auxiliary wheels 32 is smaller than the diameter of the traveling wheel 31. The height of the axles 32a of the pair of auxiliary wheels 32 is equal. The axle 32a of each of the auxiliary wheels 32 is positioned lower than the axle 31a of the traveling wheel 31. With the above-described support member 36 (see FIG. 4), the relative positional relationship between the traveling wheel 31 (axle 31a) and the pair of auxiliary wheels 32 (axles 32a) is fixed with the axle 31a and the two axles 32a parallel to each other.

The lower ends of the pair of auxiliary wheels 32 are positioned at approximately the same height. As illustrated in FIG. 8(b), as an example, the traveling wheel 31 is disposed on the first travel surface R1a at the outermost in the Y direction (plus (+) side in the Y direction in the figure), and the pair of auxiliary wheels 32 are positioned between the traveling wheel 31 and the inner end surface of the first rail R1. The term "outermost" here refers to the positional relationship as seen from the traveling vehicle 2. Of the pair of auxiliary wheels 32, for example, one auxiliary wheel 32 and the (other) auxiliary wheel 32 behind in the travel direction are shifted in position in the direction of the axle 32a (Y direction). Therefore, the traveling position (travel path) of the traveling wheel 31 in the Y direction is different from the traveling position (travel path) of one auxiliary wheel 32 and the traveling position (travel path) of the other auxiliary wheel 32. The traveling wheels 31 always travel inside the auxiliary member 80 in the width direction and do not contact with the auxiliary member 80.

With reference to the intersection rail R3, the first rail R1 on the upstream side is disposed on the upstream side (front side) in the traveling direction and the first rail R1 on the downstream side is disposed on the downstream side (back side) in the traveling direction. For example, the auxiliary member 80 provided at the end of the first rail R1 on the upstream side is provided at a position and a height corresponding to the auxiliary wheel 32 behind. The auxiliary member 80 provided at the end of the first rail R1 on the downstream side is provided at a position and a height corresponding to the auxiliary wheel 32 in front.

Referring again to FIG. 5, the track R is explained. In the track R, between a plurality of the first rails R1, a plurality of the second rails R2, and intersection rails R3 disposed at the intersections of these first and second rails R1 and R2, a plurality of gaps G through which the connecting parts 35 (see FIG. 3) below the traveling wheels 31 can pass are formed. The connecting part 35 connects the traveling wheel 31 to the cart unit 50 of the traveling cart 20.

As illustrated in FIG. 9(a), when the traveling wheel 31 reaches the gap G, the auxiliary wheel 32 behind rides on the auxiliary travel surface 81h of the auxiliary member 80 and travels on the auxiliary member 80. Consequently, the auxiliary wheel 32 is supported by the auxiliary travel surface 81h, and falling of the traveling wheel 31 into the gap G is suppressed. Thus, vibration of the traveling vehicle 2 when the traveling wheels 31 pass over the gap G is suppressed. As illustrated in FIG. 9(b), the auxiliary wheel 32 may still be on the auxiliary travel surface 81h when the traveling wheel 31 is on the intersection rail R3. Even when the traveling wheels 31 pass over the gap G between the intersection rail R3 and the downstream first rail R1, the auxiliary wheel 32 in front and the auxiliary member 80 suppress the falling of the traveling wheels 31 into the gap G, and suppress the vibration of the traveling vehicle 2 when the traveling wheels 31 pass over the gap G.

In other words, the lower end of the traveling wheel 31 or the lower end of any of the auxiliary wheels 32 is always in contact with some support surface (the first travel surface R1a or the auxiliary travel surface 81h). Consequently, the traveling wheels 31 or any of the auxiliary wheels 32 are supported by some support surface. The position and the length of the auxiliary member 80 to be provided are set based on the diameter of the traveling wheel 31, the diameter of the auxiliary wheel 32, and the positional relationship (separation distance in the X direction) of the axle 32a of the auxiliary wheel 32 to the axle 31a of the traveling wheel 31.

The intersection rail R3 in the track R is not merely for the traveling wheels 31 and the auxiliary wheels 32 to linearly pass through, but is also used for direction changes. An auxiliary member 80 provided on the intersection rail R3 will interfere with the traveling (or passing, or direction changes) of the traveling vehicle 2. Therefore, there is no auxiliary member 80 provided in the intersection rail R3. The intersection rail R3 includes only the intersection travel surface R3a being flat and horizontal on its upper surface. With regard to the position, the height, and the length of the auxiliary member 80 in the present embodiment, the same ideas can be used as for the design of the position, the height, and the length of the auxiliary track described in Patent No. 7040636 (Patent Literature 1 above). In the present embodiment, the diameter of the traveling wheel 31, the diameter of the auxiliary wheel 32, and the positional relationship of the axle 32a of the auxiliary wheel 32 to the axle 31a of the traveling wheel 31 can be changed as needed.

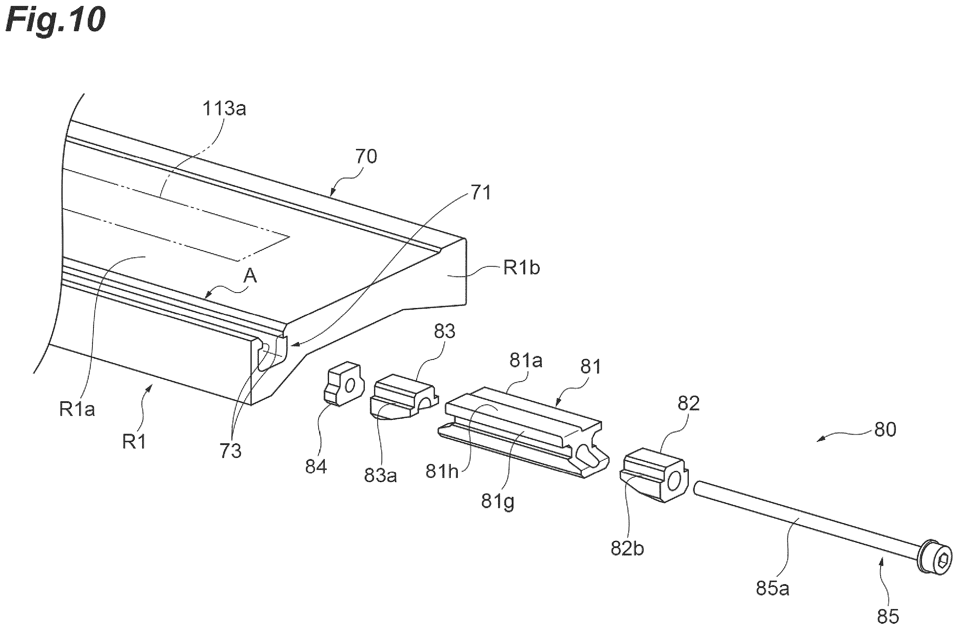

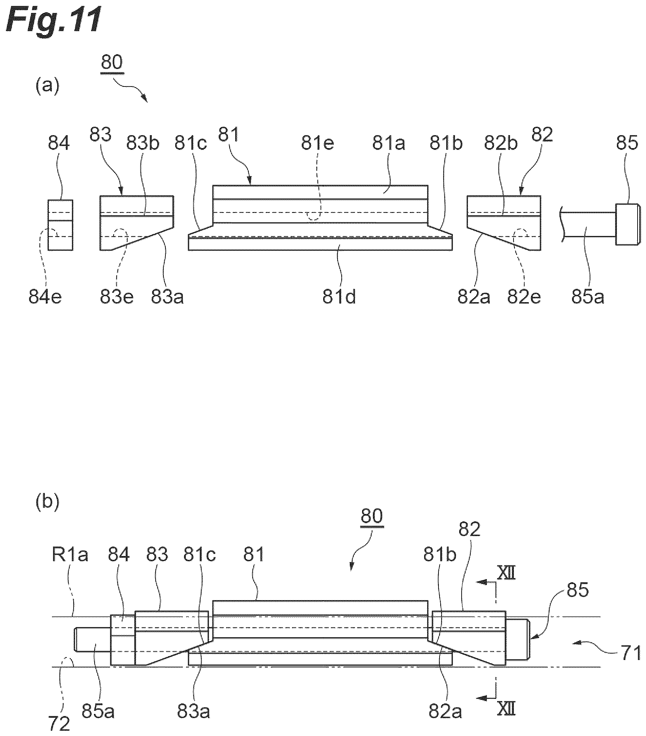

Referring to FIGs. 10, 11(a) and 11(b), details of the auxiliary member 80 are described. FIG. 10 is an exploded perspective view illustrating the auxiliary member 80. FIG. 11(a) is a side view of the auxiliary member 80 before assembly, and FIG. 11(b) is a side view of the auxiliary member 80 after assembly (when fixed). As illustrated in FIGs. 10 and 11(a), the auxiliary member 80 has a body 81 including a protruding portion 81g forming the auxiliary travel surface 81h, a first holding section 82 including a first holding slope 82a being in contact with the body 81 from one side in the longitudinal direction (X direction) of the first rail R1, a second holding section 83 including a second holding slope 83a being in contact with the body 81 from the other side in the longitudinal direction (X direction) of the first rail R1, and nuts 84 and screws 85 sandwiching and fastening the body 81, the first holding slope 82a, and the second holding section 83.

A through hole 81e is formed in the body 81. A through hole 82e is formed in the first holding section 82, and a through hole 83e is formed in the second holding section 83. A hole 84e is formed in the nut 84. The through hole 81e, the through hole 82e, the through hole 83e, and the hole 84e are disposed in a straight line. A threaded shaft 85a of the screw 85 is inserted through the through hole 81e, the through hole 82e, the through hole 83e and the hole 84e. On the inner surface of the hole 84e, a female thread is formed, and on the end of the threaded shaft 85a, a male thread being screwed into the female thread of the nut 84 is formed.

As illustrated in FIG. 11(b), a first receiving slope 81b facing diagonally upward is formed on one side of the body 81, and a second receiving slope 81c facing diagonally upward is formed on the other side of the body 81. The inclination angle of the first receiving slope 81b and the second receiving slope 81c are equal, for example. In the first holding section 82, a first holding slope 82a facing diagonally downward and being in contact with the first receiving slope 81b is formed. The inclination angle of the first holding slope 82a is equal to that of the first receiving slope 81b. In the second holding section 83, a second holding slope 83a facing diagonally downward and being in contact with the second receiving slope 81c is formed. The inclination angle of the second holding slope 83a is equal to that of the second receiving slope 81c.

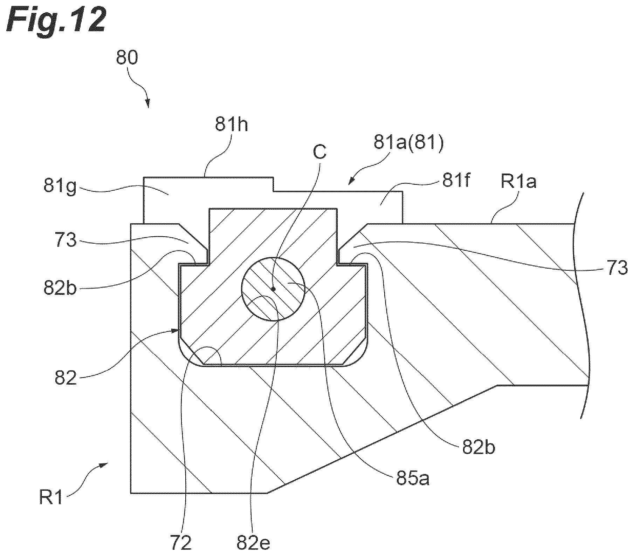

FIG. 12 is a cross-sectional view along the XII-XII line in FIG. 11(b). As illustrated in FIGs. 11(b) and 12, the through hole 81e of the body 81, the through hole 82e of the first holding section 82, the through hole 83e of the second holding section 83, and the hole 84e of the nut 84 are aligned (on the X direction line), and in the groove 71, the body 81, the first holding section 82, the second holding section 83, and the nut 84 are disposed with the threaded shaft 85a inserted thereinto. The bottoms of the first holding section 82 and the second holding section 83 ride on the bottom surface 72 of the groove 71, while the upper surface portion 81a (the protruding portion 81g and a low wall portion 81f) overhanging both sides of the body 81 in the Y direction ride on the first travel surface R1a. By tightening the screw 85 in this state, the above-described slopes are in contact with each other and the first holding section 82 and second holding section 83 are brought into close proximity to the body 81. By further tightening the screw 85, the above-described slopes rub against each other and the first holding section 82 and the second holding section 83 rise in the groove 71 (slightly away from the bottom surface 72). A stepped portion 82b of the first holding section 82 and a stepped portion 83b of the second holding section 83 are pressed against a pair of-protruding portions 73 extending in the X direction formed near the opening of the groove 71. As a result, the pair of protruding portions 73 are correspondingly sandwiched between an upper surface portion 81a of the body 81 and a stepped portion 82b of the first holding section 82, and between the upper surface portion 81a of the body 81 and a stepped portion 83b of the second holding section 83, to secure the body 81. On the head of the screw 85, a mating hole in which a rotary tool fits is formed. When tightening the screw 85, the rotary tool is turned in a state of being positioned in the groove 71. To allow sliding in an up-down direction between the slopes, for example, the diameters of the through holes 82e and 83e are larger than the diameter of the through hole 81e.

As illustrated in FIG. 12, the protruding portion 81g, that is, the auxiliary travel surface 81h, is formed at a position shifted to one side (one side or the other side) of the centerline C of the groove 71 in the width direction of the rail body 70 (left-right direction in the figure). The centerline C coincides with the centerline of the threaded shaft 85a, for example. For example, the width of the auxiliary travel surface 81h may be equal to the width of the low wall portion 81f. In that case, the auxiliary travel surface 81h is located in an area of only one side of the centerline C of the groove 71 in the width direction of the rail body 70 (left-right direction in the figure).

As illustrated in FIG. 7, the two auxiliary members 80 are installed in opposite directions with respect to the rail body 70. In one auxiliary member 80, the screw 85 is inserted from the one end face R1b of the rail body 70. In the other auxiliary member 80, the screw 85 is inserted from the other end face R1c of the rail body 70. Consequently, the two auxiliary travel surfaces 81h, which are formed at biased positions in the width direction as described above, form two support surfaces in different positions in the direction of the axle 32a, illustrated in FIG. 8(b).

According to the first rail R1 and the second rail R2 of the present embodiment, when the traveling wheel 31 passes over the gaps G correspondingly formed between the first rail R1 and the intersection rail R3 and between the second rail R2 and the intersection rail R3, the auxiliary wheel 32 is supported on the auxiliary travel surface 81h of the auxiliary member 80. The first travel surface R1a and the second travel surface R2a and the auxiliary member 80 are separate bodies from each other, and the auxiliary member 80 is removably attached to the attachment portion A. Therefore, the rail body 70 including the first travel surface R1a and the second travel surface R2a and the auxiliary member 80 including the auxiliary travel surface 81h can be produced separately (by using separate molds, or other method), and thus cost reduction is enabled. Conventional integrated type travel rail requires special processing (machining or the like) of the rail members, and thus cause a cost increase. The cost issues are greatly improved in the first rail R1 and the second rail R2 of the present embodiment. The auxiliary member 80 being removably attached to the attachment portion A facilitates adjustment of the position of the auxiliary travel surface 81h and change of the height by replacement.

The attachment portion A is the groove 71 formed at the end in the longitudinal direction and extending in the longitudinal direction. Consequently, the installation of the auxiliary member 80 is facilitated. If the groove 71 is longer than the auxiliary member 80, the auxiliary member 80 can also be moved along the groove 71, and the position of the auxiliary member 80 including the auxiliary travel surface 81h can be easily adjusted.

By tightening screw 85 with the body 81, the first holding section 82, the second holding section 83, and the nut 84 disposed in the groove, the body 81 is attached and secured. By using the first holding section 82 and the second holding section 83 of a wedge shape, the body 81 (auxiliary member 80) can be attached simply by tightening the screws 85. The auxiliary member 80 can be removed simply by loosening the screw 85. It is easy to attach and detach the auxiliary member 80 to and from the rail body 70. By replacing only the body 81 constituting the auxiliary member 80, the length or the height, or the like of the auxiliary travel surface 81h can be changed more easily and at a lower cost.

The auxiliary travel surface 81h is formed at a position shifted to one side or the other of the centerline C of the groove 71 in the width direction orthogonal to the longitudinal direction and along the first travel surface R1a and the second travel surface R2a. This configuration is advantageous when the pair of auxiliary wheels 32 are provided as in the above embodiment, and the traveling position of the auxiliary wheels 32 in the direction of the axle 32a is shifted. In other words, by fitting a common body 81 into the groove 71 in the opposite direction, two kinds of auxiliary travel surfaces 81h with different positions in the direction of the axle 32a can be formed. The traveling position of the auxiliary wheel 32 being shifted allows the auxiliary wheel 32 to come in contact with the auxiliary travel surface 81h only when the traveling wheel 31 is off the first travel surface R1a or the second travel surface R2a. Therefore, when the driving force is generated by the traveling wheel 31, the auxiliary wheels 32 and the auxiliary travel surface 81h do not cause the traveling wheel 31 to be separated from the first travel surface R1a or the second travel surface R2a.

According to the overhead vehicle system 1 of the present embodiment, the auxiliary wheels 32 traveling on the auxiliary member 80 can suppress the traveling wheel 31 from falling into the gap G when the traveling wheel 31 passes over the gap G, thereby suppressing vibration of the traveling vehicle 2. At least any one of the height, the length, or the position of the auxiliary member 80 for being in contact with the auxiliary wheel 32 (for supporting the auxiliary wheel 32) can be easily changed.

Although the embodiment of the present disclosure is described above, the invention is not limited to the above embodiment. For example, it is not limited to cases where the lower ends of the pair of auxiliary wheels 32 are positioned higher than the lower end of the traveling wheels 31. For example, the lower end of the auxiliary wheel 32 may be positioned lower than the lower end of the traveling wheel 31. In that case, on the rail body 70, a lower step surface (another rail upper surface) than the first travel surface R1a or the second travel surface R2a is formed, and when the traveling wheel 31 comes into contact with the first travel surface R1a or the second travel surface R2a, the auxiliary wheel 32 is located above that lower step surface. An auxiliary member is provided protruding from that lower step surface. The lower ends of the pair of auxiliary wheels 32 may be located at somewhat different heights.

The groove 71 may not penetrate the rail body 70 in the X direction, but may be formed for a predetermined length from each of the one end face R1b and the other end face R1c. In that case, the length of the groove 71 is greater than the length of the auxiliary member 80.

The attachment portion A is not limited to the groove 71. A configuration in which a recessed portion or a depression or the like is provided in the first travel surface R1a and/or the second travel surface R2a and the auxiliary member 80 is fitted into the recessed portion or the depression may be adopted. Alternatively, an auxiliary member 80 which is a separate body may simply be fixed on the first travel surface R1a and/or the second travel surface R2a. In such cases, screw fastening or adhesion or other means may be used as the fixing method.

The specific configuration of the auxiliary member 80 may be modified from the above embodiment. For example, any one of the first holding section 82 and the second holding section 83 may be omitted. The nut 84 may be omitted, and instead a female thread may be formed in the through hole 83e or the like of the second holding section 83. Not limited to tightening the screws 85, for example, a configuration may be employed in which the auxiliary member is fixed with a single touch by engaging the members with each other.

The center position of the auxiliary travel surface 81h in the width direction may be located on a vertical plane containing the centerline C of the groove 71. In that case, the one auxiliary wheel 32 and the other auxiliary wheel 32 may form two grooves (two attachment portions) in different positions in the direction of the axle 32a.

The positions of the pair of auxiliary wheels 32 in the direction of the axle 32a may be the same. In such a case, the two grooves described above are not required and one groove is sufficient. Only one auxiliary wheel 32 may be provided per one traveling wheel 31.

The above embodiment describes a case in which the four swivel axes L30 in the traveling part 30 and wheel swivel mechanism 40 are disposed at the vertices of a square in plan view, but the disposition of the swivel axes L30 need not be square-shaped. In plan view, the position of the traveling wheels 31 may coincide with the position of the swivel axis L30.

In the above embodiment, the case in which the traveling wheel 31 rotates on the intersection rail R3 is described, but each of the traveling wheels 31 may transfer from the first travel surface R1a to the second travel surface R2a or from the second travel surface R2a to the first travel surface R1a when swiveling by the corresponding wheel swivel mechanism 40.

The above embodiment describes the case in which the traveling vehicle is an overhead transport vehicle, but the traveling vehicle may also be a tracked cart configured to travel on rails (track) provided on the ground.

In the above embodiment, a grid system is employed as the transport system SYS, but the transport system SYS is not limited to a grid system. For example, AGV (Automated Guided Vehicle) may be employed as the transport system, or various known systems traveling on a travel path in a grid may be employed. In the above embodiment, the cart V holds the article M below the track R. However, the body 10 may be disposed above the track R and hold the article M on the upper side of the track R.

### Reference Signs List

1...Overhead vehicle system (traveling vehicle system)
2...Overhead traveling vehicle
5...System controller
8...Cart controller (control section)
10...Body
18...Transfer device
20...traveling cart
30...Traveling part
31...traveling wheel
31a...Axle
32...Auxiliary wheel
32a...Axle
33...Traveling drive motor
35...Connecting part
40...Wheel swivel mechanism
43...Steering motor
50...Cart unit
70...Rail body
71...Groove
80...Auxiliary member
81...Body
81g...Protruding portion
81h...Auxiliary travel surface
82...First holding section
82a...First holding slope
83...Second holding section
83a...Second holding slope
84...Nut
85...Screw
100...Rail unit
110...First rail member
113....First support wall
120...Second rail member
123...Second support wall
130...Intersection rail member
140...Connecting member
200...Rail assembly
A...Attachment portion
C...Centerline (of groove)
D1...First traveling direction
D2...Second traveling direction
G...Gap
H...Hanging member
M...Article
R...Track (track in a grid)
R1...First rail (travel rail)
R2...Second rail (travel rail)
R3... Intersection rail
R1a...First travel surface
R2a...Second travel surface
R3a...Intersection travel surface

## Claims

1. Travel rail on which a traveling vehicle travels, the traveling vehicle having a traveling wheel coming into contact with a rail upper surface and auxiliary wheels each located above the rail upper surface when the traveling wheel comes into contact with the rail upper surface, and which can be disposed in a grid in a first direction and in a second direction orthogonal to the first direction,
the travel rail being disposed such that a gap through which a connecting part provided below the traveling wheel is able to pass is formed between the travel rail and an intersection rail disposed at an intersection in the grid,
the travel rail comprising an auxiliary member configured to be removably attached to an attachment portion provided at an end of a longitudinal direction, the auxiliary member protruding from the rail upper surface and coming into contact with the auxiliary wheel.

2. The travel rail according to claim 1, wherein the attachment portion is a groove formed on the end in the longitudinal direction and extending in the longitudinal direction.

3. The travel rail according to claim 2, wherein
the auxiliary member has a body, a holding section including a holding slope being in contact with the body from at least one side of the longitudinal direction, and a screw penetrating and clamping the body and the holding section together, and
by tightening the screw in a state where the body, the holding section, and the screw are disposed in the groove, the body is attached to the attachment portion.

4. The travel rail according to claim 2 or 3, wherein an auxiliary travel surface of the auxiliary member coming into contact with the auxiliary wheel is formed at a position shifted to one side or other side of the centerline of the groove in a width direction orthogonal to the longitudinal direction and along the rail upper surface.

5. A traveling vehicle system comprising:
the travel rail according to any one of claims 1 to 3; and
the traveling vehicle configured to travel along the travel rail.

6. A traveling vehicle system comprising: the travel rail according to claim 4; and
the traveling vehicle configured to travel along the travel rail, in which the auxiliary wheels are disposed, in the width direction, at positions shifted to one side and other side of the centerline of the groove.
